(19) Europäisches Patentamt
European Patent Office
Office européen des brevets

(11) **EP 4 357 772 B1**

(12) **FASCICULE DE BREVET EUROPEEN**

(45) Date de publication et mention
de la délivrance du brevet:
**16.07.2025 Bulletin 2025/29**

(21) Numéro de dépôt: **23203511.3**

(22) Date de dépôt: **13.10.2023**

(51) Classification Internationale des Brevets (IPC):
***G01N 29/24*** *(2006.01)* ***G01N 29/36*** *(2006.01)*

(52) Classification Coopérative des Brevets (CPC):
**G01N 29/36; G01N 29/2406;** G01N 2291/014

(54) **CAPTEUR MEMS RESONANT ADAPTE POUR GENERER UN SIGNAL DE SORTIE A IMPULSIONS**

RESONANTER MEMS-SENSOR ZUR ERZEUGUNG EINES IMPULSAUSGANGSSIGNALS

RESONANT MEMS SENSOR ADAPTED TO GENERATE A PULSED OUTPUT SIGNAL

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **20.10.2022 FR 2210836**

(43) Date de publication de la demande:
**24.04.2024 Bulletin 2024/17**

(73) Titulaire: **Commissariat à l'Energie Atomique et aux Energies Alternatives
75015 Paris (FR)**

(72) Inventeurs:
• **HARDY, Emmanuel**
**38054 GRENOBLE Cedex 09 (FR)**
• **FAIN, Bruno**
**38054 GRENOBLE Cedex 09 (FR)**
• **VIANELLO, Elisa**
**38054 GRENOBLE Cedex 09 (FR)**

(74) Mandataire: **Atout PI Laplace
Immeuble Up On
25 Boulevard Romain Rolland
CS 40072
75685 Paris Cedex 14 (FR)**

(56) Documents cités:
**EP-A1- 4 067 830 US-A1- 2007 152 682**

• **STEDMAN QUINTIN ET AL: "Improved Interface Circuits for CMUT Chemical Sensors", 2019 IEEE INTERNATIONAL ULTRASONICS SYMPOSIUM (IUS), IEEE, 6 October 2019 (2019-10-06), pages 989 - 992, XP033671516, DOI: 10.1109/ULTSYM.2019.8926206**

**Description**

Domaine technique

La présente invention concerne les capteurs MEMS (pour « Microelectromechanical systems » en anglais) résonants. Ces capteurs MEMS résonants forment une large famille de capteurs MEMS : capteurs de masse, capteurs de gaz, accéléromètres, etc. Ces capteurs fonctionnent autour d'une fréquence de résonance, qui dépend du paramètre d'intérêt. Dans le cas d'un capteur de gaz, la fréquence de résonance dépend directement de la masse de la structure mobile, qui dépend elle-même des espèces adsorbées à la surface et donc de la concentration en gaz. Dans le cas d'un accéléromètre résonant, la fréquence d'une structure mobile résonante dépend de l'accélération via le déplacement quasistatique d'une masse soumise aux efforts inertiels. Pour l'ensemble de ces capteurs, le signal mécanique d'intérêt est un signal alternatif, même lorsque le signal à mesurer est un signal DC (accélération constante, ou concentration en gaz constante).

Le signal issu du MEMS est traité par une électronique d'interface, notée « analogue front-end » (Dit AFE) par la suite. A la sortie de l'AFE, le signal peut être traité de différentes manières, par une électronique embarquée, ou par des unités de traitements déportés, en temps réel ou en différé, de manière à délivrer l'information pertinente.

L'invention porte sur l'ensemble des capteurs MEMS résonants. Elle est particulièrement pertinente quand le traitement du signal est réalisé en temps réel par des traitements de type neuromorphique embarqué en temps réel, c'est-à-dire des traitements imitant le fonctionnement des neurones.

Technique antérieure

US 2007/152682 A1 divulgue un capteur capacitif.

Durant les dernières années les capteurs se sont multipliés dans de nombreux domaines (IoT, automobile, etc.). Les données issues de ces capteurs sont de plus en plus traitées par des traitements de type « machine learning », qui permettent d'extraire une information pertinente à partir d'un grand nombre de données. Ces traitements peuvent se faire sur des unités digitales classiques, i.e. des microprocesseurs dont les transistors reproduisent la structure d'un réseau de neurones, ou bien, de manière avantageuse, avec des circuits dont la structure hardware mime au plus près le fonctionnement d'un réseau de neurones. Ce type de circuit a plusieurs avantages :

- Réduction de la consommation de plusieurs ordres de grandeurs
- Pas de stockage intermédiaire des données générées
- Pas de transfert de données vers une unité de contrôle externe
- Traitement en temps réel.

Ce type de circuits repose sur des réseaux de neurones à impulsions (SNN pour « spiking neural network »). Cependant, le couplage optimal avec les capteurs générant les impulsions est rarement effectué. Nous définissons comme « spike-based sensor » tout type de capteurs auquel est ajouté une électronique traitant l'information comme une suite d'évènements ou d'impulsions sans passer par un convertisseur analogique-numérique classique. Dans l'article « Towards spike-based machine intelligence with neuromorphic computing » de K. Roy, A. Jaiswal, and P. Panda, Nature, vol. 575, no. 7784, pp. 607-617, Nov. 2019, doi: 10.1038/s41586-019-1677-2, un état de l'art des traitements neuromorphiques en circuit intégré est présenté. Ces « spike-based sensors » sont utilisés pour la vision, comme il est indiqué dans le document « A Spike-Based Neuromorphic Architecture of Stereo Vision » de N. Risi, A. Aimar, E. Donati, S. Solinas, and G. Indiveri dans Frontiers in Neurorobotics, vol. 14, 2020, Accessed: Jul. 07, 2022. [Online]. Available: https:// www.frontiersin.org /articles/10.3389/fnbot.2020.568283. Ces « spike-based sensors » sont également utilisés pour l'audio, comme il est indiqué dans le document "AER EAR: a matched silicon cochlea pair with address event representation interface," de A. van Schaik and S.-C. Liu dans 2005 IEEE International Symposium on Circuits and Systems (ISCAS), May 2005, pp. 4213-4216 Vol. 5. doi: 10.1109/ISCAS.2005.1465560.

En ce qui concerne les capteurs d'odeur, il est proposé dans le document « Rapid online learning and robust recall in a neuromorphic olfactory circuit » de N. Imam and T. A. Cleland dans Nature Machine Intelligence, vol. 2, no. 3, pp. 181-191, Mar. 2020, doi: 10.1038/s42256-020-0159-4 une conversion temps-réel en impulsion de la tension de sortie après conversion en numérique d'un « chemo-sensor » mesurant les changements de conductivité. Cette étape de conversion en numérique rend le système sous-optimal mais elle permet de réaliser facilement la conversion en impulsions avec des composants électroniques du marché.

Il existe de nombreux travaux sur les capteurs résonants et sur la manière de lire la fréquence de résonance avec l'échantillonnage et la résolution souhaitée.

On peut notamment citer des approches faisant intervenir une PLL (pour « Phase-Locked Loop »en anglais). Dans ce type d'architecture, la structure résonante est excitée à sa fréquence de résonance via un asservissement en phase. La fréquence d'excitation reproduit donc une variable d'intérêt comme il est expliqué dans le document « Frequency-addressed NEMS arrays for mass and gas sensing applications » de E. Sage et al. dans 2013 Transducers & Eurosensors XXVII: The 17th International Conference on Solid-State Sensors, Actuators and Microsystems (TRANSDUCERS & EUROSENSORS XXVII), Jun. 2013, pp. 665-668. doi: 10.1109/Transducers.2013.6626854.

D'autres approches font intervenir une boucle d'auto-oscillation comprenant le MEMS et une électronique d'amplification comme il est indiqué dans le document « Improved Interface Circuits for CMUT Chemical Sensors » de Q. Stedman, J. D. Fox, and B. T. Khuri-Yakub dans 2019 IEEE International Ultrasonics Symposium (IUS), Oct. 2019, pp. 989-992. doi: 10.1109/ULTSYM.2019.8926206. Avec un bon dimensionnement, ce type d'architecture se met naturellement à osciller à une fréquence proche de la fréquence de résonance. Un deuxième étage électronique réalise la fonction de compteur de fréquence, qui donne un signal de sortie numérique proportionnel à la fréquence d'auto-oscillation. Un type particulier de capteur est le nez électronique. Il s'agit d'un ensemble de capteurs, par exemple « gravimétrique », présentant chacun une affinité chimique particulière envers les différents gaz susceptibles d'être mesurés. Ainsi, la réponse de chaque capteur à un ensemble de gaz donné est particulière. Le traitement des données issues des différents capteurs permet de remonter à la composition du gaz. Ce principe, qui mime le fonctionnement du nez humain, porte le nom de nez électronique.

Dans le cas d'un nez électronique à base de capteurs gravimétriques résonants (cMUT, SAW, NEMS, microbalance à quartz...), le signal de chaque capteur est une fréquence de résonance, ou d'auto-oscillation.

Le traitement de l'information consiste donc à détecter pour chaque capteur la valeur de la fréquence de résonance, puis à combiner les différentes fréquences pour extraire l'information quant à la nature (et la quantité) du gaz. Ce traitement se fait via une base de données de référence. Dans le cas d'un traitement de type « machine learning », cette base de données sert à l'apprentissage, qui permettra la classification.

Il existe un besoin de proposer une architecture générique pour des capteurs MEMS résonants adaptés pour délivrer des signaux sous forme d'impulsions.

Exposé de l'invention

La présente invention vise à remédier au moins en partie à ce besoin.

Plus particulièrement, la présente invention a pour objectif de couvrir un capteur MEMS résonant adapté pour générer un signal de sortie à impulsions à partir d'un signal d'intérêt, ledit signal d'intérêt étant un signal carré ayant une fréquence oscillant autour d'une fréquence porteuse, ledit capteur MEMS comprenant au moins un canal de traitement du signal d'intérêt, chaque canal de traitement comportant :

- un bloc de démodulation du signal d'intérêt pour former un signal démodulé, ledit bloc de démodulation comprenant un mixeur de fréquence entre ledit signal d'intérêt et un signal de référence, ledit signal démodulé ayant une composante basse fréquence et une composante haute fréquence ;
- un bloc de filtration du signal démodulé pour former un signal filtré, le bloc de filtration étant adapté pour laisser passer la composante basse fréquence du signal démodulé ;
- un bloc de comparaison du signal filtré avec un signal seuil fixe pour former un signal de comparaison, ledit signal de comparaison comprenant des fronts montants et des fronts descendants ;
- un bloc de détection des fronts montants, chaque front montant correspondant à une impulsion du signal de sortie.

Ainsi, l'invention permet d'obtenir une architecture générique pour les capteurs MEMS résonants dont on mesure la fréquence porteuse appelée également fréquence de résonance, de manière à ce que ces capteurs soient des « spike-based sensors », délivrant des signaux sous forme d'impulsions. En termes d'électronique les avantages sont nombreux, notamment pour l'intégration. En outre, la nature binaire du signal le rend très robustes aux perturbations électromagnétiques. De plus, la quantité d'impulsions est proportionnelle à l'activité/intensité du signal. Ce qui permet une consommation réduite lorsque le signal est peu présent ou absent. C'est le capteur MEMS résonant, via son électronique de conditionnement, qui est adapté pour générer le signal de sortie à impulsions.

Dans un mode de réalisation particulier, le capteur comprend un transducteur CMUT adapté pour générer le signal d'intérêt à partir d'une variation d'une caractéristique physique étudiée.

Dans un mode de réalisation particulier, la caractéristique physique étudiée à partir de laquelle le signal d'intérêt est généré est sélectionnée dans un groupe de caractéristiques physiques comprenant au moins :

- un gaz ;
- une masse ;
- une accélération.

Dans un mode de réalisation particulier, le capteur comprend au moins deux canaux de traitement, chaque canal de traitement ayant un transducteur CMUT déterminé en vue de générer un signal de sortie à impulsions particulier audit canal de traitement.

Dans un mode de réalisation particulier, chaque canal de traitement est couplé en sortie à un classificateur, ledit classificateur étant adapté pour classifier la caractéristique physique étudiée.

Dans un mode de réalisation particulier, le classificateur est adapté pour traiter des données numériques et en ce que chaque canal de traitement comprend un bloc de conversion d'impulsions en données numériques.

Dans un mode de réalisation particulier, le classificateur est un réseau de neurones à impulsions.

L'utilisation d'un tel classificateur est particulièrement pertinent dans le cas de capteurs matriciels ou multi-canaux qui sont autant d'entrées parallèles pour le circuit neuromorphique.

Dans un mode de réalisation particulier, le capteur comprend un détecteur de transitions, ledit détecteur de transitions étant adapté pour mettre en veille tout ou partie des canaux de traitement si la caractéristique physique étudiée ne varie pas au cours d'une certaine période, ledit détecteur de transitions étant adapté pour sortir de la veille tout ou partir des canaux de traitement si la caractéristique physique étudiée varie rapidement.

Dans un mode de réalisation particulier, le capteur MEMS comprend un bloc de calibration du signal de référence dans le bloc de démodulation.

La présente invention sera mieux comprise à la lecture de la description détaillée de modes de réalisation pris à titre d'exemples nullement limitatifs et illustrés par les dessins annexés sur lesquels :

[Fig 1] la figure 1 illustre un capteur MEMS résonant selon un premier mode de réalisation de l'invention ;

[Fig 2] la figure 2 illustre un capteur MEMS résonant selon un second mode de réalisation de l'invention comportant une pluralité de canaux de traitement ;

[Fig 3] la figure 3 illustre le principe de conversion des impulsions générés par les capteurs MEMS de figures 1 et 2 vers un signal numérique ;

[Fig 4] la figure 4 illustre un capteur MEMS résonant selon un troisième mode de réalisation de l'invention ;

[Fig 5] la figure 5 illustre le principe de détection de transitions sur chaque canal de traitement du capteur MEMS résonant de la figure 2 ;

[Fig 6] la figure 6 illustre un capteur MEMS résonant selon un quatrième mode de réalisation de l'invention.

L'invention n'est pas limitée aux modes de réalisation et variantes présentées et d'autres modes de réalisation et variantes apparaîtront clairement à l'homme du métier.

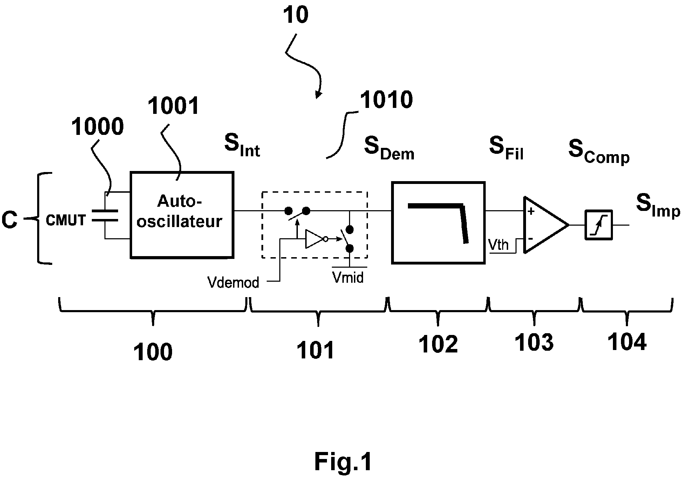

La figure 1 illustre un capteur MEMS résonant 10 selon un premier mode de réalisation de l'invention. Dans ce mode de réalisation le capteur MEMS résonant comporte :

- un ensemble 100 ;
- un bloc de démodulation 101 ;
- un bloc de filtration 102 ;
- un bloc de comparaison 103 ;
- un bloc de détection 104.

L'ensemble 100 est adapté pour générer un signal d'intérêt $S_{Int}$ à partir d'une variation d'une caractéristique physique étudiée. Une telle caractéristique physique étudiée est, par exemple, un gaz, une masse ou une accélération. On notera que le signal d'intérêt $S_{Int}$ est ici un signal périodique, par exemple un signal carré. Par signal carré, on entend un signal alternant régulièrement et instantanément entre deux niveaux.

Plus particulièrement, l'ensemble 100 comprend un capteur CMUT 1000 et un auto-oscillateur 1001. Cette électronique d'auto-oscillation est conçue de manière à ce que le MEMS se mette spontanément en oscillation lorsque l'électronique est alimentée, notamment par une tension DC. La fréquence d'oscillation d'un MEMS résonant est dictée par sa structure mécanique, dessinée pour obtenir les performances souhaitées. Par exemple, dans le cas d'un transducteur cMUT, cette fréquence peut être comprise entre 10 et 50 MHz pour une bande passante de 100 kHz.

Le bloc de démodulation 101 est adapté pour démoduler le signal d'intérêt $S_{Int}$ pour former un signal analogique démodulé $S_{Dem}$. Ce bloc de démodulation 101 comprend un mixeur de fréquence 1010 entre le signal d'intérêt $S_{Int}$ et un signal de référence $V_{demod}$. Ce signal analogique démodulé $S_{Dem}$ a une composante basse fréquence et une composante haute fréquence. L'électronique de démodulation a ainsi pour rôle de ramener le signal à une fréquence faible entre 0 Hz et la valeur de sa bande passante, 100 kHz dans notre exemple. En cas d'absence de signal physique d'intérêt, par exemple en cas de non accélération ou d'absence de gaz, l'électronique de démodulation ramène le signal une fréquence nulle. Ceci permet d'avoir un signal DC en l'absence de signal physique d'intérêt, ce qui permet de limiter la consommation de certains blocs ultérieurs.

Le traitement réalisé par le bloc de démodulation 101 repose sur le principe du mixage de fréquence entre un signal d'intérêt $\sin(w_0 + dw)t$ appelé $S_{Int}$ et un signal de référence $\sin w_0 t$ appelé ($V_{demod}$). C'est la méthode hétérodyne, basée sur une multiplication de plusieurs fréquences illustrée par l'équation suivante :

$$\sin(w_0t) * \sin(w_0+dw)t = \frac{1}{2}*\cos(dwt) - \frac{1}{2}*\cos(2w_0+dw)t$$

dans laquelle $w_0$ correspond à une pulsation et $dw$ correspond à une variation de pulsation.

Le mixage en fréquence fait ici intervenir des switches. L'utilisation de switch on/off sur le signal d'intérêt $S_{Int}$ revient à le mixer avec un signal carré.

Le bloc de filtration 102 du signal démodulé $S_{Dem}$ est adapté pour former un signal analogique filtré $S_{Fil}$. Il permet ainsi de laisser passer la composante basse fréquence du signal analogique démodulé $S_{Dem}$. Ce bloc de filtration 102 est également appelé « Low Pass Filter ».

Le bloc de comparaison 103 est adapté pour comparer le signal filtré $S_{Fil}$ avec un signal seuil fixe Vth pour former un signal de comparaison $S_{Comp}$. Ce signal de comparaison $S_{Comp}$ comprend des fronts montants et des fronts descendants. Ce bloc de comparaison 103 est également appelé « comparator ».

Le bloc de détection 104 est adapté pour détecter des fronts montants. Chaque front montant va correspondre à une impulsion du signal de sortie $S_{Imp}$. Ce bloc de détection 104 est également appelé « Rising Edge ».

Le transducteur CMUT 100, le bloc de démodulation 101, le bloc de filtration 102, le bloc de comparaison 103, le bloc de détection 104 forment un canal de traitement C ou voie du capteur MEMS 10.

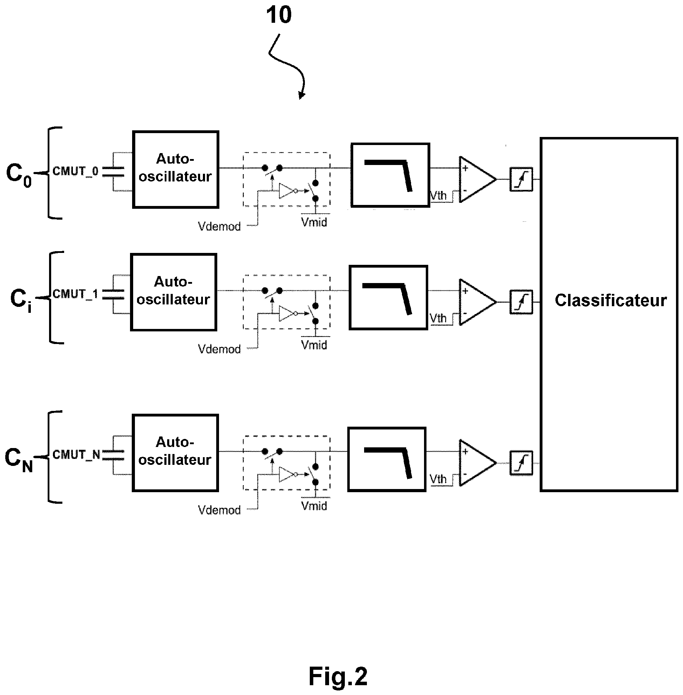

La figure 2 illustre un capteur MEMS résonant selon un second mode de réalisation de l'invention comportant une pluralité de canaux de traitement $C_0$, .., $C_i$, ..., $C_N$. Un tel capteur est appelé cMUT ou capteur cMUT multi-voies. Chaque canal de traitement $C_0$,.., $C_i$, ..., $C_N$ comprend un transducteur CMUT, un bloc de démodulation, un bloc de filtration, un bloc de comparaison et un bloc de détection. L'ensemble des canaux de traitement $C_0$, .., $C_i$, ..., $C_N$ est couplé en sortie à un même classificateur, par exemple un classificateur de type réseau de neurones à impulsions SNN. Un tel classificateur est adapté pour classifier la caractéristique physique étudiée.

On notera que le couplage entre un cMUT et le SNN n'est pas évident car les expertises sont portées par des acteurs différents, issus de communautés différentes.

On notera également que dans le cas d'un accéléromètre résonant, on peut concevoir un système mono-voie qui délivre une information temporelle sous forme d'impulsions, qui est traité pour analyser le type de mouvements. A titre de comparaison, les algorithmes de fusion de données au sein d'un smartphone permettent de déterminer si le porteur du smartphone marche, est dans un train, une voiture.

Un système formé par plusieurs accéléromètres résonants mesurant l'accélération suivant les 3 axes peut également être proposé.

De manière générale, toute combinaison avec d'autres types de capteurs résonants (gyromètres, capteur de pression, ...) peut amener à la réalisation d'un « spike-based sensor » délivrant des signaux pertinents au SNN.

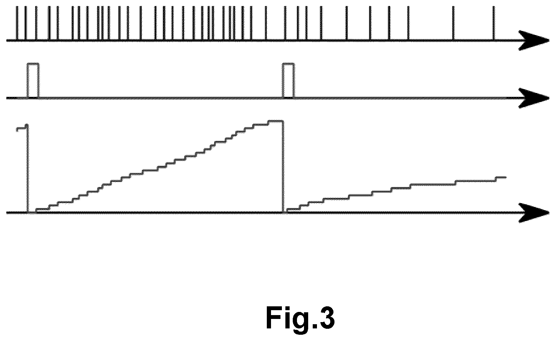

Dans le cas où les signaux ne sont pas directement utilisés par un SNN, un bloc électronique permet de convertir le signal à impulsions en un signal numérique contenant l'information sur la fréquence d'oscillation du MEMS. La figure 3 montre le principe d'un tel bloc avec en entrée une série d'impulsions asynchrones (ligne supérieure sur la figure), un compteur d'impulsions asynchrone (ligne intermédiaire) et un signal de référence (ligne inférieure) qui envoie un signal de réinitialisation du compteur avec une fréquence fixe, permettant la mesure d'une densité d'impulsions.

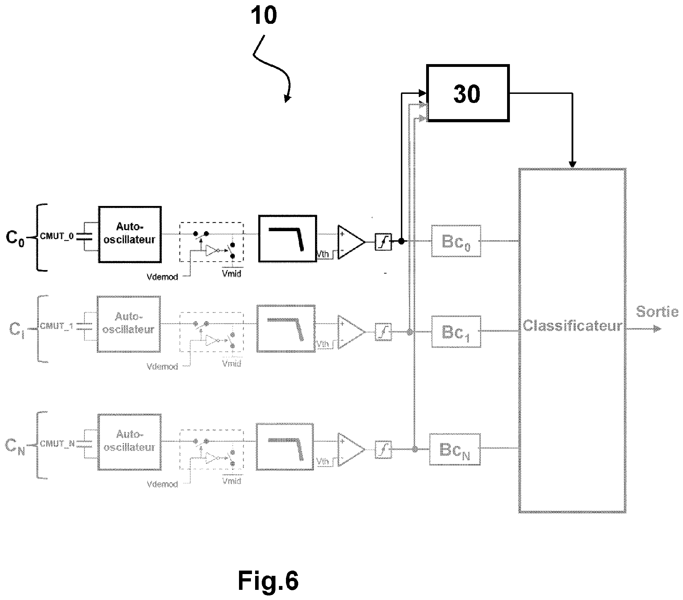

Le bloc électronique permettant de convertir le signal est illustré sur la figure 6 et en positionné en sortie d'un bloc de détection. Sur cette figure, chaque canal de traitement $C_0$, .., $C_i$, ...$C_N$ comprend un bloc de conversion $Bc_0$, .., $Bc_i$, ...$Bc_N$ d'impulsions en données numériques. Ces blocs de conversion $Bc_0$, , $Bc_i$, .., $Bc_N$ sont destinés à alimenter un système de classification qui n'est pas un SNN. Pour que la démodulation hétérodyne fonctionne de manière optimale, avec une densité d'impulsions égale à 0 quand le CMUT résonne à sa fréquence à vide $f_0=w_0/2\pi$, il faut que le signal de démodulation en entrée du mixeur ait une fréquence égale à cette fréquence à vide.

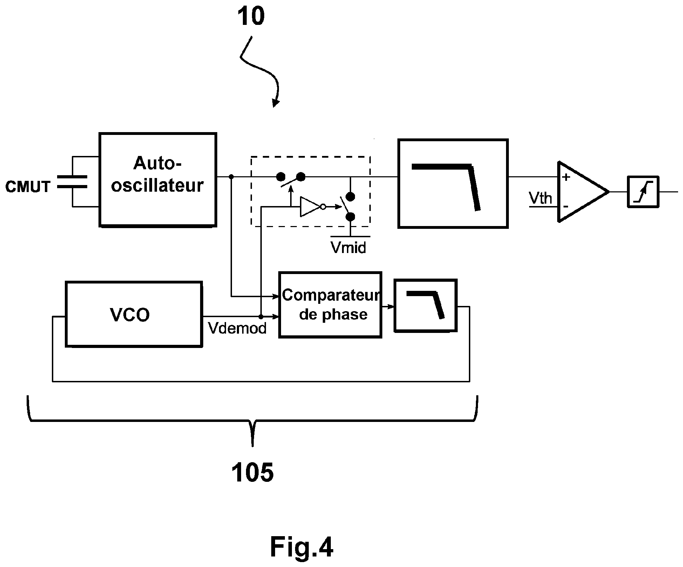

La Figure 4 présente une possibilité de circuit de calibration 105 où le CMUT résonne à $w_0$. Le signal de référence Vdemod est généré par un oscillateur contrôlé en fréquence (VCO). Sa fonction de transfert tension vers phase est un intégrateur. On fait la différence de phase entre Vdemod et la sortie de l'auto-oscillateur avec un comparateur de phase. Un filtre passe-bas est ajouté pour stabiliser la tension de commande du VCO.

En fonctionnement normal, on coupe la boucle de rétroaction du circuit de calibration et on maintient la tension calibrée en entrée du VCO.

Ce circuit peut aussi être utilisé pour compenser les dérives en fonctionnement avec un algorithme approprié, par exemple une détection de minimum sur une large fenêtre temporelle.

Certains classificateurs d'odeur peuvent fonctionner seulement sur les états stabilisés du capteur. Si c'est le cas, un détecteur de transition peut permettre d'inhiber le classificateur lorsque l'état des capteurs n'a pas atteint la stabilité.

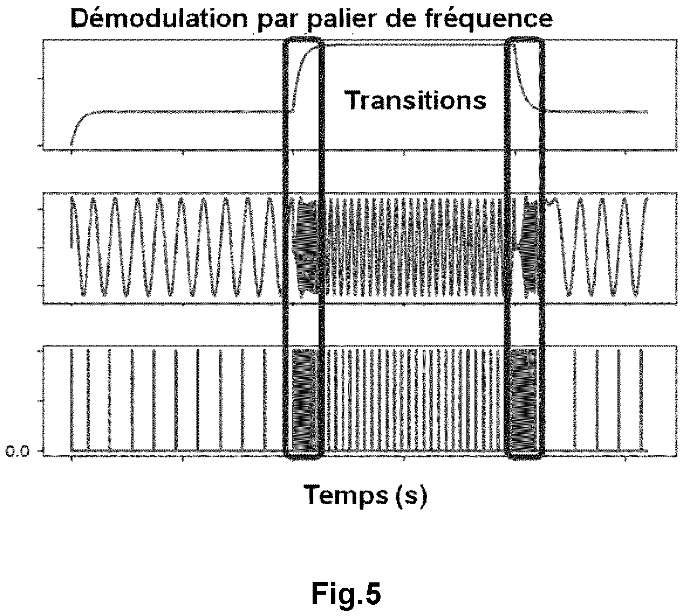

La Figure 5 montre que lors des transitions, le signal démodulé devient haute fréquence. Cela s'explique par le fait que le « step » de fréquence contient toutes les fréquences qui se démodulent dans la bande de base. En haut, la fréquence de modulation variant au cours du temps, au milieu la sortie du filtre passe bas après démodulation et en bas le train d'impulsions.

Sur la Figure 6, on ajoute au moins un détecteur de transitions 30 relié à chaque canal. Ce détecteur de transition 30 peut ainsi transmettre au classificateur un message de contrôle dit message « inference_enable » pour signifier audit classificateur si la mesure est stabilisée ou non. On peut détecter ces transitions à l'aide d'un compteur de fréquence comme sur la Figure 3, ou bien avec un neurone « Leaky Integrate and Fire » implémenté de façon analogique ou numérique. On notera que sur cette figure 6, les canaux de traitement $C_1$ à $C_N$ sont en transparence par rapport au canal de traitement $C_0$ de sorte à indiquer que ces canaux $C_1$ à $C_N$ sont en veille.

En observant que les canaux sont corrélés les uns aux autres, il est possible pour le capteur d'odeur de fonctionner dans un mode basse-consommation avec au moins un canal allumé pour détecter la présence d'un gaz avec le détecteur de transitions décrit plus haut (voir la figure 6). Lorsqu'un gaz est détecté, les autres canaux s'allument pour permettre une classification.

Cette architecture est bien évidemment particulièrement pertinente si le traitement du signal se fait par « machine learning », notamment en cas de couplage avec un circuit de traitement neuromorphique à impulsions. En particulier, elle s'applique bien aux capteurs matriciels ou multi-voies, qui sont autant d'entrées parallèles pour le circuit neuromorphique. Le cas du nez électronique est le cas-cible le plus intéressant puisque le principe même du capteur s'appuie sur une classification, parfois réalisé avec du « machine learning ».

Cette invention s'inscrit dans le cadre de systèmes low-power, ce qui soustend des architectures particulières (pas d'ADC, pas de compteur de fréquence). Néanmoins, l'invention s'applique également pour des systèmes qui ne sont pas low-power.

## Revendications

1. Capteur MEMS résonant adapté pour générer un signal de sortie à impulsions ($S_{Imp}$) à partir d'un signal d'intérêt ($S_{Int}$), ledit signal d'intérêt ($S_{Int}$) étant un signal ayant une fréquence oscillant autour d'un fréquence porteuse, ledit capteur MEMS (10) comprenant au moins un canal de traitement (C) du signal d'intérêt($S_{Int}$), chaque canal de traitement (C) comportant :

   - un bloc de démodulation (101) du signal d'intérêt ($S_{Int}$) pour former un signal démodulé ($S_{Dem}$), ledit bloc de démodulation (101) comprenant un mixeur de fréquence (1010) entre ledit signal d'intérêt ($S_{Int}$) et un signal de référence ($V_{demod}$), ledit signal démodulé ($S_{Dem}$) ayant une composante basse fréquence et une composante haute fréquence ;
   - un bloc de filtration (102) du signal démodulé ($S_{Dem}$) pour former un signal filtré ($S_{Fil}$), le bloc de filtration (12) étant adapté pour laisser passer la composante basse fréquence du signal démodulé ($S_{Dem}$) ;
   - un bloc de comparaison (103) du signal filtré ($S_{Fil}$) avec un signal seuil fixe (Vth) pour former un signal de comparaison ($S_{Comp}$), ledit signal de comparaison ($S_{Comp}$) comprenant des fronts montants et des fronts descendants ;
   - un bloc de détection (104) des fronts montants, chaque front montant correspondant à une impulsion du signal de sortie ($S_{Imp}$).

2. Capteur MEMS selon la revendication 1, ledit capteur (10) étant adapté pour générer le signal d'intérêt ($S_{Int}$) à partir d'une variation d'une caractéristique physique étudiée.

3. Capteur MEMS selon la revendication 2, la caractéristique physique étudiée à partir de laquelle le signal d'intérêt ($S_{Int}$) est généré est sélectionnée dans un groupe de caractéristiques physiques comprenant au moins :

   - un gaz ;
   - une masse ;
   - une accélération.

4. Capteur MEMS selon l'une quelconque des revendications 1 à 3, ledit capteur (10) comprenant au moins deux canaux de traitement ($C_0$, ..$C_i$, ...$C_N$), chaque canal de traitement ayant un transducteur CMUT (100) déterminé en vue de générer un signal de sortie à impulsions ($S_{Imp0}$, ..., $S_{Impi}$,..., $S_{ImpN}$) particulier audit canal de traitement ($C_0$, $C_i$, ...$C_N$).

5. Capteur MEMS selon la revendication 4, dans lequel chaque canal de traitement ($C_0$, .., $C_i$, ..., $C_N$) est couplé en sortie à un classificateur, ledit classificateur étant adapté pour classifier la caractéristique physique étudiée.

6. Capteur MEMS selon la revendication 5, dans lequel le classificateur est adapté pour traiter des données numériques et dans lequel chaque canal de traitement ($C_0$, .., $C_i$, ..., $C_N$) comprend un bloc de conversion ($Bc_0$, .., $Bc_i$, .., $Bc_N$) d'impulsions en données numériques.

**7.** Capteur MEMS selon l'une quelconque des revendications 5 ou 6, dans lequel le classificateur est un réseau de neurones à impulsions.

**8.** Capteur MEMS selon l'une quelconque des revendications 5 à 7, dans lequel ledit capteur comprend un détecteur de transitions (30), ledit détecteur de transitions (30) étant adapté pour mettre en veille tout ou partie des canaux de traitement ($C_0$, .., $C_i$, ...$C_N$) si la caractéristique physique étudiée ne varie pas au cours d'une certaine période.

**9.** Capteur MEMS selon l'une quelconque des revendications 1 à 8, dans lequel ledit capteur MEMS comprend un bloc de calibration (105) du signal de référence ($V_{demod}$) dans le bloc de démodulation (101).

**Patentansprüche**

**1.** Resonanter MEMS-Sensor, angepasst zum Erzeugen eines Impulsausgangssignals ($S_{imp}$) anhand eines Signals von Interesse ($S_{int}$), wobei das Signal von Interesse ein Signal mit einer Frequenz ist, die um eine Trägerfrequenz oszilliert, wobei der MEMS-Sensor (10) mindestens einen Verarbeitungskanal (C) des Signals von Interesse umfasst, wobei jeder Verarbeitungskanal (C) Folgendes umfasst:

- eine Demodulationseinheit (101) des Signals von Interesse zum Bilden eines demodulierten Signals ($S_{Dem}$), wobei die Demodulationseinheit (101) einen Frequenzmischer (1010) zwischen dem Signal von Interesse und einem Referenzsignal ($V_{demod}$) umfasst, wobei das demodulierte Signal ($S_{Dem}$) eine Niederfrequenzkomponente und eine Hochfrequenzkomponente aufweist;
- eine Filtereinheit (102) des demodulierten Signals ($S_{Dem}$) zum Bilden eines gefilterten Signals ($S_{Fil}$), wobei die Filtereinheit (12) zum Durchlassen der Niederfrequenzkomponente des demodulierten Signals ($S_{Dem}$) angepasst ist;
- eine Vergleichseinheit (103) des gefilterten Signals ($S_{Fil}$) mit einem festen Schwellenwertsignal ($V_{th}$) zum Bilden eines Vergleichssignals ($S_{Comp}$), wobei das Vergleichssignal ($S_{Comp}$) ansteigende Flanken und abfallende Flanken umfasst;
- eine Erkennungseinheit (104) der ansteigenden Flanken, wobei jede ansteigende Flanke einem Impuls des Ausgangssignals ($S_{Imp}$) entspricht.

**2.** MEMS-Sensor nach Anspruch 1, wobei der Sensor (10) zum Erzeugen des Signals von Interesse anhand einer Änderung einer untersuchten physikalischen Charakteristik angepasst ist.

**3.** MEMS-Sensor nach Anspruch 2, wobei die untersuchte physikalische Charakteristik, anhand derer das Signal von Interesse ($S_{Int}$) erzeugt wird, ausgewählt ist aus einer Gruppe von physikalischen Charakteristiken, die mindestens Folgendes umfasst:

- ein Gas;
- eine Masse;
- eine Beschleunigung.

**4.** MEMS-Sensor nach einem der Ansprüche 1 bis 3, wobei der Sensor (10) mindestens zwei Verarbeitungskanäle ($C_0$, ... $C_i$, ... $C_N$) umfasst, wobei jeder Verarbeitungskanal einen CMUT-Wandler (100) aufweist, der zum Erzeugen eines für den Verarbeitungskanal ($C_0$, ... $C_i$, ... CN) spezifischen Impulsausgangssignals ($S_{Imp0}$, ..., $S_{Impi}$, ..., $S_{ImpN}$) bestimmt ist.

**5.** MEMS-Sensor nach Anspruch 4, wobei jeder Verarbeitungskanal ($C_0$, ..., $C_i$, ..., $C_N$) am Ausgang mit einem Klassifikator gekoppelt ist, wobei der Klassifikator zum Klassifizieren der untersuchten physikalischen Charakteristik angepasst ist.

**6.** MEMS-Sensor nach Anspruch 5, wobei der Klassifikator zum Verarbeiten digitaler Daten angepasst ist, und wobei jeder Verarbeitungskanal ($C_0$, ..., $C_i$, ..., $C_N$) eine Umwandlungseinheit ($Bc_0$, ..., $Bc_i$, ..., $Bc_N$) von Impulsen in digitale Daten umfasst.

**7.** MEMS-Sensor nach einem der Ansprüche 5 oder 6, wobei der Klassifikator ein neuronales Impulsnetzwerk ist.

**8.** MEMS-Sensor nach einem der Ansprüche 5 bis 7, wobei der Sensor einen Übergangsdetektor (30) umfasst, wobei der Übergangsdetektor (30) zum Versetzen einiger oder aller Verarbeitungskanäle ($C_0$, ..., $C_i$, ... $C_N$) in Standby angepasst ist, wenn sich die untersuchte physikalische Charakteristik während eines bestimmten Zeitraums nicht ändert.

9. MEMS-Sensor nach einem der Ansprüche 1 bis 8, wobei der MEMS-Sensor eine Kalibrierungseinheit (105) des Referenzsignals ($V_{demod}$) in der Demodulationseinheit (101) umfasst.

**Claims**

1. A resonant MEMS sensor adapted to generate a pulse output signal ($S_{Imp}$) from a signal of interest ($S_{Int}$), said signal of interest ($S_{Int}$) being a signal having a frequency oscillating around a carrier frequency, said MEMS sensor (10) comprising at least one processing channel (C) for processing the signal of interest ($S_{Int}$), each processing channel (C) containing:

   - a demodulation unit (101) for demodulating the signal of interest ($S_{Int}$) to form a demodulated signal ($S_{Dem}$), said demodulation unit (101) comprising a frequency mixer (1010) between said signal of interest ($S_{Int}$) and a reference signal ($V_{demod}$), said demodulated signal ($S_{Dem}$) having a low-frequency component and a high-frequency component;
   - a filtration unit (102) for filtering the demodulated signal ($S_{Dem}$) to form a filtered signal ($S_{Fil}$), the filtration unit (12) being adapted to allow the low-frequency component of the demodulated signal ($S_{Dem}$) to pass through;
   - a comparison unit (103) for comparing the filtered signal ($S_{Fil}$) with a fixed threshold signal (Vth) to form a comparison signal ($S_{Comp}$), said comparison signal ($S_{Comp}$) comprising rising edges and falling edges;
   - a detection unit (104) for detecting rising edges, each rising edge corresponding to a pulse of the output signal ($S_{Imp}$).

2. The MEMS sensor according to claim 1, said sensor (10) being adapted to generate the signal of interest ($S_{Int}$) from a variation in a studied physical feature.

3. The MEMS sensor according to claim 2, the studied physical feature from which the signal of interest ($S_{Int}$) is generated being selected from a group of physical features comprising at least:

   - a gas;
   - a mass;
   - an acceleration.

4. The MEMS sensor according to any one of claims 1 to 3, said sensor (10) comprising at least two processing channels ($C_0$, ..., $C_i$, ..., $C_N$), each processing channel having a CMUT transducer (100) determined in order to generate a pulse output signal ($S_{Imp0}$, ..., $S_{Impi}$, ..., $S_{ImpN}$) specific to said processing channel ($C_0$, ..., $C_i$, ..., $C_N$).

5. The MEMS sensor according to claim 4, wherein each processing channel ($C_0$, ..., $C_i$, ..., $C_N$) is coupled, at its output, to a classifier, said classifier being adapted to classify the studied physical feature.

6. The MEMS sensor according to claim 5, wherein the classifier is adapted to process digital data and wherein each processing channel ($C_0$, ..., $C_i$, ..., $C_N$) comprises a conversion unit ($Bc_0$, ..., $Bc_i$, ..., $Bc_N$) for converting pulses to digital data.

7. The MEMS sensor according to any one of claims 5 or 6, wherein the classifier is a pulse neural network.

8. The MEMS sensor according to any one of claims 5 to 7, wherein said sensor comprises a transition detector (30), said transition detector (30) being adapted to set all or some of the processing channels ($C_0$, ..., $C_i$, ..., $C_N$) to standby if the studied physical feature does not vary over a certain period.

9. The MEMS sensor according to any one of claims 1 to 8, wherein said MEMS sensor comprises a calibration unit (105) for calibrating the reference signal ($V_{demod}$) in the demodulation unit (101).

**Fig.1**

**10**

**Fig.2**

# Fig.3

**10**

CMUT

Auto-oscillateur

Vmid

Vth

VCO

Vdemod

Comparateur de phase

**105**

**Fig.4**

# Démodulation par palier de fréquence

Transitions

Temps (s)

# Fig.5

**10**

**Fig.6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2007152682 A1

**Littérature non-brevet citée dans la description**

- **K. ROY** ; **A. JAISWAL** ; **P. PANDA**. *Nature*, November 2019, vol. 575 (7784), 607-617, doi: 10.1038/s41586-019-1677-2
- **N. RISI** ; **A. AIMAR** ; **E. DONATI** ; **S. SOLINAS** ; **G. INDIVERI**. A Spike-Based Neuromorphic Architecture of Stereo Vision. *Frontiers in Neurorobotics*, 2020, vol. 14, https://www.frontiersin.org /articles/10.3389/fnbot.2020.568283
- **A. VAN SCHAIK** ; **S.-C. LIU**. *dans 2005 IEEE International Symposium on Circuits and Systems (ISCAS)*, May 2005, vol. 5
- **N. IMAM** ; **T. A. CLELAND**. Rapid online learning and robust recall in a neuromorphic olfactory circuit. *Nature Machine Intelligence*, March 2020, vol. 2 (3), 181-191
- **E. SAGE et al.** Frequency-addressed NEMS arrays for mass and gas sensing applications. *2013 Transducers & Eurosensors XXVII: The 17th International Conference on Solid-State Sensors, Actuators and Microsystems (TRANSDUCERS & EUROSENSORS XXVII),*, June 2013, 665-668
- **Q. STEDMAN** ; **J. D. FOX** ; **B. T. KHURI-YAKUB**. Improved Interface Circuits for CMUT Chemical Sensors. *2019 IEEE International Ultrasonics Symposium (IUS)*, October 2019, 989-992